# EUROPEAN PATENT SPECIFICATION

(11) **EP 2 133 445 B1**
(45) Date of publication and mention of the grant of the patent: **08.08.2012**
(21) Application number: 08157866.8
(22) Date of filing: 09.06.2008
(51) Int. Cl.: C23C 14/56, H01L 21/00

(54) **Coating System and Method for Coating a Substrate**
Beschichtungssystem und Verfahren zur Beschichtung eines Substrats
Système de revêtement et procédé de revêtement d'un substrat

(43) Date of publication of application: 16.12.2009
(73) Proprietor: Applied Materials, Inc., Santa Clara, CA 95054 (US)
(72) Inventor: Koparal, Erkan, 61130 Nidderau (DE)
(74) Representative: Lermer, Christoph

(56) References cited:
- EP-A- 1 801 843
- US-A1- 2003 159 919
- US-A1- 2007 020 903

## Description

### TECHNICAL FIELD

The present invention relates to a coating system for processing a substrate, comprising: an arrangement of chambers including a first process chamber and a second process chamber; wherein said first process chamber is arranged on a forward path of an in-line portion of said coating system, and said second process chamber is arranged on a return path of an in-line portion of said coating system. Furthermore, the present invention relates to a method for coating a substrate, particularly in a coating system as described above.

### PRIOR ART

In a number of technical applications multiple layer stacks are deposited on a substrate in a sequence of coating steps. For example, in a TFT (Thin Film Transistor) metallization process two or three different metals are deposited by a sputtering process. Due to different coating rates in different process steps and due to different thickness of the layers the processing time in the coating stations for depositing different layers may vary considerably.

In order to deposit a multiple layer stack a number of configurations of coating and treatment chambers have been suggested. For example, in-line arrangements of coating chambers are used as well as cluster arrangements of coating chambers. A typical cluster arrangement comprises a central handling chamber and a number of coating chambers connected thereto. The coating chambers may be equipped to carry out the same or different coating processes. However, whereas in in-line systems the handling of the process is quite easy, the processing time is determined by the longest processing time. Therefore, the efficiency of the process is affected. Cluster tools, on the other hand, allow for different cycle times. However, the handling may be quite complex which requires an elaborate transfer system provided in the central handling chamber.

An alternative concept which combines in-line and cluster concepts has been described in document EP 1 801 843 A1 the content of which is incorporated herein be reference. The document describes a coating system for depositing a TFT layer stack having a lock-in chamber, a metallization station for a first metallization process, a central handling chamber, two metallization stations for a second metallization process, and a second metallization station for the first process. The metallization chambers for the second process are arranged parallel with each other and used alternatively. The process chambers for the first metallization process are arranged in-line such that every substrate is processed in both chambers. The cycle time of the system is reduced by the combination of an in-line and a cluster concept as the combination minimizes handling complexity while increasing the throughput.

Document US 2007/020 903 A1 discloses a method for making a film stack and a processing system for forming the film stack on a substrate.

However, in case a particular coating chamber has to undergo a maintenance or cleaning process, e.g. for changing a sputter target, the operation of the coating system has to be stopped completely.

### OBJECT OF THE INVENTION

It is an object of the present invention to increase the overall throughput and the efficiency of a coating system, particularly for TFT metal applications.

### TECHNICAL SOLUTION

This object is solved by providing a coating system according to claim 1, and a method for coating a substrate according to claim 11. The dependent claims refer to preferred features of the invention.

A coating system for processing a substrate according to the invention comprises: an arrangement of chambers including a first process chamber and a second process chamber; wherein the first process chamber is arranged on a forward path of an in-line portion of the coating system, and the second process chamber is arranged on a return path of an in-line portion of the coating system. The first process chamber and the second process chamber are both arranged between a first transfer chamber and a second transfer chamber which are configured to transfer a substrate from the forward path of the first in-line portion to the return path of the second in-line portion and vice versa.

The forward path is defined as the path of movement of the substrate from a lock-in chamber to the second transfer chamber and the return path is defined as the path of movement of a substrate from the second transfer chamber to a lock-out chamber in a regular operational mode, i.e. if both the first and second process chambers are in operation. For the transport along a transport path the substrates may be supported in a substrate carrier. The substrates may be attached to the substrate carrier. In another embodiment the substrates may pass through the coating system without a carrier, e. g. by means of an air cushion transport system.

The first process chamber and the second process chamber are arranged parallel and in-line with the lock-in/lock-out station and the first transfer chamber. The first transfer chamber is arranged between the lock-in/lock-out station and the first process chamber and the second chamber process chamber, and configured to transfer a substrate received from the lock-in/lock-out station to the first process chamber and the second process chamber, respectively. Furthermore, the coating system comprises a second transfer chamber arranged in-line with the first process chamber and the second process chamber and configured to transfer a substrate received from the first process chamber or the second process chamber to another chamber.

The process chambers may be any treatment stations, particularly coating stations for depositing a layer or a layer stack on a first substrate. In a TFT coating process two, three or more metal layers are deposited on the first substrate. The first process chamber and the second process chamber may be metal coating stations, e.g. for providing a Mo layer by means of a first sputter process. The third process chamber and the fourth process chamber may be metal coating stations, e.g. for providing an A1 layer on the first substrate by means of a second sputter process. Further substrates, e.g. a second, a third, a fourth substrate etc. may enter the coating system and be processed in the coating system sequentially and contemporaneously with the first substrate. I.e. the different process and transfer steps may overlap.

The coating system is characterized by the particular arrangement of handling and process stations. Both transfer chambers may receive substrates from each of the process chambers and feed a substrate into both of the first and second process chambers. Therefore, in case one of the first or second process chambers is shut down due to reparation, maintenance, cleaning, etc., the other one of the first and second process chambers may still be in operation and process substrates passing through the process chamber. Of course, when one of the first or second process chambers is shut down the cycle time for processing a substrate increases because each substrate passes either the first or the second process chamber in both directions. Thus there is a bottleneck in the in-line path due to the missing first or second process chamber. The throughput and the efficiency of the overall coating system is reduced when the forward path and the return path share a particular process chamber. However, it may be avoided that the operation of the complete coating system has to be stopped, thus improving the availability of the coating system.

Compared with the concept described in document EP 1 801 843 A1 a further transfer chamber has been introduced which allows a substrate on an in-line path to bypass a particular coating station using a corresponding coating station arranged parallel with the particular coating station. This inventive concept may be applied to every coating system, wherein a process chamber in a forward path of an in-line system (or combined in-line -cluster system) is arranged parallel with a corresponding process chamber in a return path of the in-line system (or combined in-line cluster system), both process chambers being arranged between a first transfer chamber and a second transfer chamber which allow a substrate to be transported on the forward path (or the return path) to bypass one of the two chambers by changing from the forward path to the return path or vice versa. The concept of is particularly suitable when the same process is usually carried out in both process chambers on the way to the third and fourth coating chambers, respectively, and on the way back from the third and fourth coating chambers, respectively.

It is preferred that the arrangement of chambers includes a lock-in/lock-out station for locking a substrate in the coating system and/or for locking a substrate out of the coating system, respectively. The first process chamber and the second process chamber are arranged in-line with the lock-in/lock-out station, the first transfer chamber, and the second transfer chamber.

Particularly, the first process chamber and the second process chamber comprise coating tools for depositing a layer on a substrate by means of a first coating process. The first coating process may be a metallization process, e.g. a Mo metallization process. The coating process may be a sputter process.

In a preferred embodiment of the invention the arrangement of chambers comprises at least a third process chamber for processing a substrate, wherein the third process chamber is coupled to the second transfer chamber.

Particularly the arrangement of chambers comprises a fourth process chamber arranged parallel with the third process chamber coupled to the second transfer chamber. The fourth process chamber may be arranged parallel with the third process chamber, and the second transfer chamber is configured to transfer a substrate received from the first process chamber and the second process chamber, respectively, either to the third process chamber or the fourth process chamber. In the third process chamber and the fourth process chamber the same coating may be deposited, e.g. the third and fourth process chambers may be metal coating stations for depositing an Al layer on the substrate by means of a sputter process. Due to the fact that the thickness of the Al layer in a TFT system is much larger than the thickness of the underlying and overlying Mo layers, the third process chamber and the fourth process chamber are operated as a cluster tool, e.g. they are loaded from the second transfer chamber alternately.

In fact, the first transfer chamber is provided for transferring a substrate between at least two of the first and the second process chambers and/or the lock-in/lock-out chambers. The second transfer chamber is provided for transferring a substrate between at least two of the first, the second, the third and/or the fourth process chambers. The first and/or the second transfer chambers may be vacuum transfer chambers.

In a regular process a first substrate is transported along a forward path from the lock-in chamber, through the first transfer chamber along a first substrate holder, into the first process chamber for obtaining a first coating therein. Then the first is transported into the second transfer chamber and into either of the third process chamber and the fourth process chamber for obtaining a second coating therein. Afterwards, the first substrate is transported on a return path back through the second transfer chamber into the second process chamber for obtaining a third coating therein. Then the first substrate is transported through the first transfer chamber into the lock-out chamber for removing the coated substrate from the coating system.

Alternatively, e.g. in case the first coating chamber is not in operation, the substrate being transported on the forward path may be transferred to the second process chamber instead in order to obtain a first coating. Alternatively on the way back to the first transfer chamber the substrate being transported on the return path may be transferred to the first process chamber instead of the second coating chamber in order to obtain a third coating, e.g. in case the second coating chamber is not in operation.

Whenever the first process chamber and the second process chamber are in operation, the combined in-line cluster system provides for a high efficiency. If one or more of the chambers are out of use, the system may still work with reduced efficiency, but the availability of the coating system may be ensured almost continuously.

It is preferred that the third process chamber and the fourth process chamber comprise coating tools for depositing a layer on a substrate using a second coating process. The second coating process may be a metallization process, e.g. an Al metallization process. The second coating process may be a sputter process.

The first process chamber and the second process chamber are configured for providing a first coating process, and the third process chamber and the fourth process chamber are configured for providing a second coating process. For example, in a TFT coating system, the first process may be a first metallization process, and the second process may be a second metallization process. One or both processes may be carried out using a sputter method.

Particularly, the lock-in/lock-out station comprises a lock-in chamber and a lock-out chamber. The lock-in chamber defines the beginning of a forward path of a substrate being processed in the coating system; the lock-out chamber defines the end of the return path of the substrate. For example, the forward path is defined between the lock-in chamber and the second transfer chamber, and the return path is defined between the second transfer chamber and the lock-out chamber. The forward path or the return path may be interrupted when a chamber arranged on the path is out of operation, e.g. due to maintenance purposes. However, the arrangement of a first transfer chamber and a second transfer chamber allows a substrate to bypass the process chamber on the return path and the forward path, respectively, because the first and the second transfer chambers are configured to transfer a substrate from a forward path to the return path of the coating system and vice versa.

It is preferred that the first transfer chamber is connected with the first process chamber and the second process chamber, the first process chamber and the second process chamber are connected with the second transfer chamber, and the third process chamber and the fourth process chamber are connected with the second transfer chamber.

The first transfer chamber may include a first rotatable module having at least one substrate holder for holding a substrate. The first rotatable module is configured to align the substrate holder relative to the first process chamber, the second process chamber, the lock-in chamber and/or the lock-out chamber to receive a substrate therefrom, or to deliver a substrate received in the transfer chamber into the respective chamber.

The second transfer chamber may include a second rotatable module having at least one substrate holder for holding a substrate. The second rotatable module is configured to align the substrate holder relative to the first process chamber, the second process chamber, the third process chamber and/or the fourth process chamber to receive a substrate therefrom, or to deliver a substrate received in the transfer chamber into the respective chamber.

Particularly, the first and/or second rotatable modules have at least a first substrate holder and a second substrate holder for holding a first substrate and/or a second substrate. The first substrate holder and the second substrate holder are arranged such that when the first substrate holder is aligned to receive a first substrate from a particular chamber or to deliver a substrate to a particular chamber, the second substrate holder is aligned to receive a second substrate from another chamber or to deliver a second substrate to another chamber. The rotatable module(s), when rotating the substrate carrier) changes the alignment of the substrate relative to the transport path. The angle of the change of the alignment corresponds to the angle of rotation of the rotatable module. Particularly, the module is rotated 180° in order to transfer the substrate from a first transport path to a second transport path.

The method for coating a substrate according to the invention in a coating system as described above, comprises the steps of:
a) locking a substrate in the coating system via a lock-in chamber;
b) transporting the substrate into a first transfer chamber;
c) transporting the substrate into either a first or a second process chamber for processing the substrate using a first process;
d) transporting the substrate into a second transfer chamber; and
e) transporting the substrate into either a third or a fourth process chamber for processing the substrate using a second process.
   It is preferred that the method further comprises the following steps:
f) transporting the substrate from the third process chamber or the fourth process chamber into the second transfer chamber; and
g) transporting the substrate into the first process chamber or the second process chamber for processing the substrate using a third process. The third process may be the same or different from the first process.

Step g) may include transporting the substrate into the same process chamber as in step c) for processing the substrate using a third process. This process is applied when one of the first or the second process chambers is out of operation, e.g. due to maintenance purposes.

The method may comprise further steps h) transporting the substrate into the first transfer chamber; and i) transporting the substrate into a lock-out chamber.

It is preferred that the method is provided for producing a TFT thin film transistor.

The method described above is sequentially repeated by processing a second and further substrates. The substrates pass the process stations sequentially. In the cluster configuration of the coating system two or more substrates (depending on the number of coating chambers for a particular process) may be processed at the same time, i.e. temporarily overlapping. In the in-line portion(s) of the configuration of the coating system the substrates are processed sequentially in each of the process chambers.

By means of the invention, a high throughput of the coating system may be achieved, while downtimes of the complete system are substantially avoided.

The features described above are claimed per se in any combination thereof.

### BRIEF DESCRIPTION OF THE DRAWING(S)

Further features and advantages of the invention will be apparent from the following description of a preferred embodiment with reference to the appended drawings. The figures illustrate
Figure 1 a schematic view of a coating system according to the present invention; and
Figure 2 different operational modes of a coating system according to the invention.

### DETAILED DESCRIPTION OF A PREFERRED EMBODIMENT

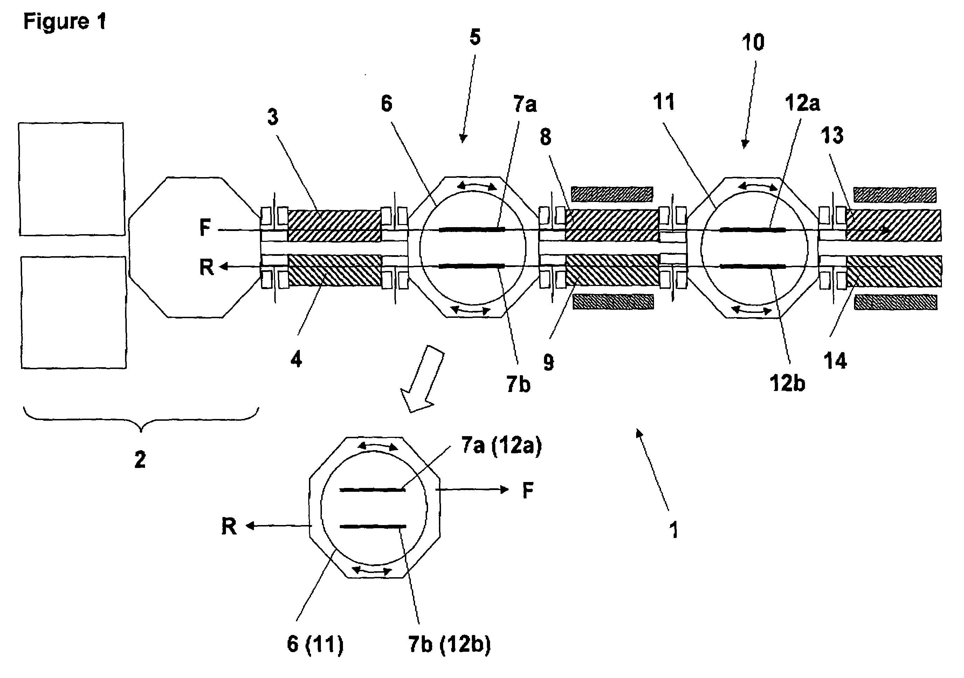

As illustrated in figure 1 a coating system 1 according to the present invention comprises a lock-in/lock-out station including a lock-in chamber 3 and a lock-out chamber 4. A substrate feeding and receiving portion 2 includes a swing module (atmospheric pressure) and an atmospheric rotation module for feeding substrates into the system 1 and/or receiving substrates processed in the system 1. Furthermore, the coating system 1 comprises a first transfer chamber 5 connected with the lock-in chamber 3 and the lock-out chamber 4.

In the transfer chamber 5 a first rotatable transfer module 6 is arranged. The rotatable transfer module 6 has two substrate holders 7a, 7b which are arranged on a rotatable platform. The substrate holders 7a, 7b may be rotated around a central axis such that the substrate holders 7a and 7b may be positioned in alignment with the lock-in chamber 3 and the lock-out chamber 4, respectively.

The coating station 1 further includes a first process chamber 8 and a second process chamber 9, both of them equipped for depositing a first metal layer, e.g. a Mo metallization layer, on a substrate. The first process chamber 8 and the second process chamber 9 are connected with the first transfer chamber 5. The rotatable transfer module 6 may be rotated such that the first substrate holder 7a is in alignment with the lock-in chamber 3 and the first process chamber 8, and the second substrate holder 7b is in alignment with the lock-out chamber 4 and the second process chamber 9 and vice versa.

Furthermore, the coating system 1 includes a second transfer chamber 10 having a second rotatable transfer module 11 including a third substrate holder 12a and a fourth substrate holder 12b. The second transfer chamber 10 is configured similar to or like the first transfer chamber 5.

The second transfer chamber is connected with the first process chamber 8 and the second process chamber 9 as well as a third process chamber 13 and a fourth process chamber 14. The third process chamber 13 and the fourth process chamber 14 are arranged parallel, i.e. like a cluster arrangement, at the second transfer chamber 10. The third process chamber 13 and the fourth process chamber 14 are equipped for depositing a second metal layer, e.g. an Al metallization layer, on the substrate. The rotatable transfer module 11 may be rotated such that the third substrate holder 12a is in alignment with the first process chamber 8 and the third process chamber 13, and the fourth substrate holder 12b is in alignment with the second process chamber 9 and the fourth process chamber 14 and vice versa.

The lock-in chamber 3, the first substrate holder 7a, and the first process chamber 8 define an in-line forward path F of the production line of a substrate. The second process chamber 9, the second substrate holder 7b and the lock-out chamber 4 define an in-line return path R of the production line. The second transfer chamber 10, the third process chamber 13 and the fourth process chamber 14 define a cluster tool with parallel process chambers 13 and 14 arranged at the second transfer chamber 10. There may be further coating chambers of the same or different kind as the third and fourth process chambers.

In a regular coating process, i.e. when the first, the second, the third and the fourth process chambers 8, 9, 13, 14 are in operation, a first substrate is locked in the system via the lock-in chamber 3 into the first transfer chamber 5. The first substrate entering the first transfer chamber 5 is transported over the first substrate holder 7a into the first process chamber to obtain a first metallization layer, e.g. a Mo layer, by means of a sputter process. Afterwards, the first substrate is transported into the second transfer chamber 10. The first substrate is then transferred into either the third process chamber 13 or the fourth process chamber 14 for receiving a second metallization layer, e.g. an Al layer, by means of a second sputter process.

Because the second layer is thicker than the first layer, the cycle time for providing the second layer in the third process chamber 13 or the fourth process chamber 14 is considerably longer than the cycle time for providing a layer in the first process chamber 8 or the second process chamber 9.

In the meantime a second substrate may have entered the second transfer chamber 10 via the lock-in chamber 3, the first transfer chamber 5 and the first process chamber 8. The second substrate is transferred into either the third process chamber 13 or the fourth process chamber 14, whichever of the process chambers 13 or 14 is not occupied by the first substrate. Afterwards, the first substrate is transferred back into the second transfer chamber 10 and the second process chamber 9 for obtaining a third metallization layer, e.g. a Mo layer, in a first sputter process.

In the meantime, a third substrate may have entered the second transfer chamber 10 and be transferred into the third process chamber 13 or the fourth process chamber 14, whichever of the process chambers 13, 14 is not occupied by the second substrate. When the first substrate is transported through the first transfer chamber 5 and the lock-out chamber 4, the second substrate is transported into the second process chamber 9 for obtaining a third metallization layer. Further substrates may follow the third substrate through the coating system 1 for depositing a TFT layer stack thereon.

In this (regular) operating mode the substrates are not transferred between the forward path F and the return path R. The first transfer chamber 5 acts as a transfer chamber for directly transferring the substrates from the lock-in chamber 3 to the first coating chamber 8 and between the second coating chamber 9 and the lock-out chamber 4. The rotation module 6 is maintained in a predetermined position.

In another situation indicated in the figure, the second process chamber 9 is out of operation due to maintenance, e.g. for exchanging a sputter target. When this happens, the first process chamber 8 acts as a process chamber for depositing the first metallization layer and the third metallization layer on each substrate processed in the coating system 1.

Particularly, a first substrate enters the coating system 1 via the lock-in chamber 3 and is transported through the first transfer chamber 5 along the first substrate holder 7a into the first process chamber 8 for obtaining a first metallization layer, e.g. Mo layer, by means of a first sputter process. Afterwards, the first substrate is transported into the second transfer chamber 10 and into either the third process chamber 13 or the fourth process chamber 14 for obtaining a second metallization layer, e.g. an Al layer, by means of a second sputter process. Afterwards, the first substrate is transported back into the second transfer chamber 10 while a second substrate enters the second transfer chamber 10 from the first process chamber 8. Afterwards, while the second substrate is transported in either the third or the fourth process chamber 13 or 14, the first substrate is aligned with the first process chamber 8 and transported back into the first process chamber 8 for obtaining a third metallization layer. Afterwards, the first substrate enters the first transfer chamber 5. The rotatable transfer module 6 is rotated such that the first substrate is aligned with the lock-out chamber 4. In this position of the rotatable transfer module 6 another substrate may enter the first transfer chamber 5 via the lock-in chamber 3. Afterwards, the third substrate is processed in the first process chamber 8.

This procedure is sequentially repeated with a new substrate entering the coating system 1 and replacing another substrate leaving the coating system 1. Of course, in case of a downtime of the first or the second coating chambers 8 or 9 (as well as of the third or fourth coating chambers 13 or 14) the cycle time for processing a determined number of substrates is increased. However, it is not necessary to stop the operation of the complete coating system 1 thus ensuring the availability of the system. During the transport through the coating systems 1 the substrates are usually aligned in a substantially vertical position. Between the chambers gate valves are installed for vacuum tight sealing of the chambers.

In the second operation mode, e.g. when the second chamber 9 is out of operation, a substrate returning from the third or fourth coating chamber 13 or 14 bypasses the second coating chamber 9. The first transport chamber 5 and the second transfer chamber 10 enable the substrate to leave the return pass R and bypass the second process chamber 9 on the forward path F.

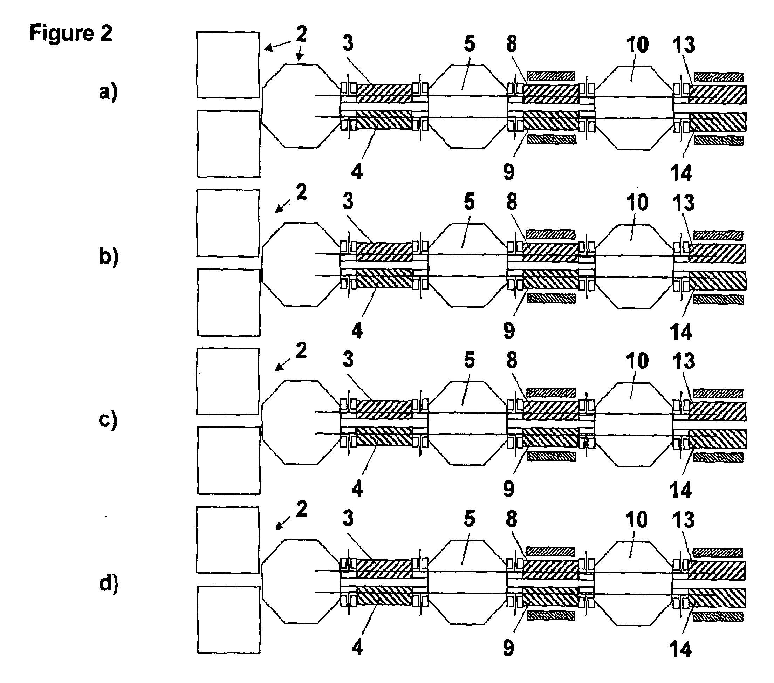

Figure 2 illustrates different operational modes of the coating system according to the invention.

In a first operational mode a. all of the first, the second, the third and the fourth process chambers 8, 9, 13 and 14 are in operation. Therefore, a regular coating process as described above may be executed. In this operational mode substrates are sequentially processed in the system in chambers 8 (Mo), 13 or 14 (Al; alternately), and 9 (Mo). I.e. the first, third, fifth, etc., substrates are processed in the third chamber, and the second, fourth, sixth, etc., substrates are processed in the fourth chamber 14. The cycle time will increase accordingly..

In a second operational mode b., the cycle time is increased s with the same deposition rates for the Mo and Al layers, but with the fourth process chamber 14 being out of operation. Therefore, the bottleneck is the Al coating process in the third and the fourth process chambers 13 and 14, respectively.

In a third operational mode c., the second process chamber 9 is out of operation. Because the Mo layer may only be deposited in the first process chamber 8 for all substrates, the cycle time increases. The bottleneck in this operational mode is the transfer and rotation of the substrates in the transfer chambers, i.e. the handling of the substrates.

In a fourth operational mode d., the first process chamber 8 and the fourth process chamber 14 are out of operation. The cycle time is increased by the bottleneck being the handling in the transfer chambers 5 and 10 as well as the Al coating in the third process chamber 13.

Generally, the invention provides for a possibility to increase the availability of the system by a sandwich arrangement of two parallel coating chambers, one of them belonging to a forward path F, the other one to a return path R between two transfer chambers which are configured to transfer a substrate from the forward path F to the return path R and vice versa.

## Claims

1. A coating system (1) for processing a substrate, comprising:
an arrangement of chambers including a first process chamber (5) and a second process chamber (9);
wherein said first process chamber (8) is arranged on a forward path (F) of an in-line portion of said coating system (1), and said second process chamber (9) is arranged on a return path (R) of an in-line portion of said coating system (1),
**characterized in that**
said first process chamber (8) and said second process chamber (9) are both arranged between a first transfer chamber (5) and a second transfer chamber (10) which are configured to transfer a substrate from the forward path (F) of the first in-line portion to the return path (R) of the second in-line portion and vice versa.

2. The coating system (1) of claim 1,
**characterized in that**
said arrangement of chambers includes a lock-in/lock-out station (2) for locking a substrate in the coating system (1) and/or for locking a substrate out of the coating system (1), respectively;
wherein the first process chamber (8) and the second process chamber (9) are arranged in-line with the lock-in/lock-out station (2), the first transfer chamber (5), and the second transfer chamber (10).

3. The coating system (1) of claim 1 or 2,
**characterized in that**
said first process chamber (8) and said second process chamber (9) comprise coating tools for depositing a layer on a substrate by means of a first coating process.

4. The coating system (1) of any of the previous claims,
**characterized in that**
said arrangement of chambers comprises at least a third process chamber (13) for processing a substrate, wherein said third process chamber (13) is coupled to said second transfer chamber (10).

5. The coating system (1) of any of the previous claims,
**characterized in that**
said arrangement of chambers comprises a fourth process chamber (14) arranged parallel with the third process chamber (13) coupled to said second transfer chamber (10).

6. The coating system (1) of any of the previous claims,
**characterized in that**
said third process chamber (13) and said fourth process chamber (14) comprise coating tools for depositing a layer on a substrate in a second coating process.

7. The coating system (1) of any of the previous claims,
**characterized in that**
said lock-in/lock-out station (2) comprises a lock-in chamber (3) and a lock-out chamber (4).

8. The coating system (1) of any of the previous claims,
**characterized in that**
said first transfer chamber (5) is connected with said first process (3) chamber and said second process chamber (4), said first process chamber (3) and said second process chamber (4) are connected with said second transfer chamber (10), and said third process chamber (13) and said fourth process chamber (14) are connected with said second transfer chamber (10).

9. The coating system (1) of any of the previous claims,
**characterized in that**
said first transfer chamber (5) includes a first rotatable module (6) having at least one substrate holder (7a, 7b) for holding a substrate.

10. The coating system (1) of any of the previous claims,
**characterized in that**
said second transfer chamber (10) includes a second rotatable module (11) having at least one substrate holder (12a, 12b) for holding a substrate.

11. A method for coating a substrate in a coating system according to any of the previous claims, comprising the steps of:
a) locking a substrate in said coating system via a lock-in chamber;
b) transporting said substrate into a first transfer chamber;
c) transporting said substrate into either a first or a second process chamber for processing said substrate using a first process;
d) transporting said substrate into a second transfer chamber; and
e) transporting said substrate into either a third or a fourth process chamber for processing said substrate using a second process.

12. The method of claim 11,
**characterized in that**
the method further comprises the following steps:
f) transporting said substrate from said third process chamber or said fourth process chamber into said second transfer chamber; and
g) transporting said substrate into said first process chamber or said second process chamber for processing said substrate using a third process.

13. The method of claim 11 or 12,
**characterized in that**
step g) includes transporting said substrate into the same process chamber as in step c) for processing said substrate using a third process.

14. The method of claim 11, 12, or 13,
**characterized in that**
the method comprises further steps h) transporting said substrate into said first transfer chamber; and i) transporting said substrate into a lock-out chamber.

15. The method of any of the claims 11 to 14,
**characterized in that**
said method is provided for producing a TFT thin film transistor.

## Patentansprüche

1. Beschichtungssystem (1) zur Bearbeitung eines Substrats, umfassend:
eine Anordnung von Kammern, umfassend eine erste Prozesskammer (5) und eine zweite Prozesskammer (9);
wobei die erste Prozesskammer (8) auf einem Vorwärtspfad (F) eines Inline-Abschnitts des Beschichtungssystems (1) angeordnet ist, und die zweite Prozesskammer (9) auf einem Rückwärtspfad (R) eines Inline-Abschnitts des Beschichtungssystems (1) angeordnet ist,
**dadurch gekennzeichnet, dass**
die erste Prozesskammer (8) und die zweite Prozesskammer (9) beide zwischen einer ersten Transferkammer (5) und einer zweiten Transferkammer (10) angeordnet sind, die so ausgebildet sind, dass ein Substrat vom Vorwärtspfad (F) des ersten Inline-Abschnitts zum Rückwärtspfad (R) des zweiten Inline-Abschnitts übergeben wird und umgekehrt.

2. Beschichtungssystem (1) nach Anspruch 1,
**dadurch gekennzeichnet, dass**
die Anordnung von Kammern eine Einschleus-/Ausschleusstation (2) zum Einschleusen eines Substrats in das Beschichtungssystem (1) und/oder zum Ausschleusen eines Substrats aus dem Beschichtungssystem (1) umfasst;
wobei die erste Prozesskammer (8) und die zweite Prozesskammer (9) in Reihe mit der Einschleus- /Ausschleusstation (2), der ersten Transferkammer (5), und der zweiten Transferkammer (10) angeordnet sind.

3. Beschichtungssystem (1) nach Anspruch 1 oder 2,
**dadurch gekennzeichnet, dass**
die erste Prozesskammer (8) und die zweite Prozesskammer (9) Beschichtungswerkzeuge zum Abscheiden einer Schicht auf einem Substrat mittels eines ersten Beschichtungsprozesses aufweisen.

4. Beschichtungssystem (1) nach einem der vorhergehenden Ansprüche,
**dadurch gekennzeichnet, dass**
die Anordnung von Kammern wenigstens eine dritte Prozesskammer (13) zum Bearbeiten eines Substrats umfasst, wobei die dritte Prozesskammer (13) an die zweite Transferkammer (10) angekoppelt ist.

5. Beschichtungssystem (1) nach einem der vorhergehenden Ansprüche,
**dadurch gekennzeichnet, dass**
die Anordnung von Kammern eine vierte Prozesskammer (14) umfasst, die parallel mit der dritten Prozesskammer (13), die an die zweite Transferkammer (10) angekoppelt ist, angeordnet ist.

6. Beschichtungssystem (1) nach einem der vorhergehenden Ansprüche,
**dadurch gekennzeichnet, dass**
die dritte Prozesskammer (13) und die vierte Prozesskammer (14) Beschichtungswerkzeuge zum Abscheiden einer Schicht auf einem Substrat in einem zweiten Beschichtungsprozess umfassen.

7. Beschichtungssystem (1) nach einem der vorhergehenden Ansprüche,
**dadurch gekennzeichnet, dass**
die Einschleus-/Ausschleusstation (2) eine Einschleuskammer (3) und eine Ausschleuskammer (4) umfasst.

8. Beschichtungssystem (1) nach einem der vorhergehenden Ansprüche,
**dadurch gekennzeichnet, dass**
die erste Transferkammer (5) an die erste Prozesskammer (3) und die zweite Prozesskammer (4) angeschlossen ist, die erste Prozesskammer (3) und die zweite Prozesskammer (4) an die zweite Transferkammer (10) angeschlossen sind, und die dritte Prozesskammer (13) und die vierte Prozesskammer (14) an die zweite Transferkammer (10) angeschlossen sind.

9. Beschichtungssystem (1) nach einem der vorhergehenden Ansprüche,
**dadurch gekennzeichnet, dass**
die erste Transferkammer (5) ein erstes Rotationsmodul (6) mit wenigstens einem Substrathalter (7a, 7b) zum Halten eines Substrats umfasst.

10. Beschichtungssystem (1) nach einem der vorhergehenden Ansprüche,
**dadurch gekennzeichnet, dass**
die zweite Transferkammer (10) ein zweites Rotationsmodul (11) mit wenigstens einem Substrathalter (12a, 12b) zum Halten eines Substrats umfasst.

11. Verfahren zum Beschichten eines Substrats in einem Beschichtungssystem nach einem der vorhergehenden Ansprüche, umfassend die Schritte:
a) Einschleusen eines Substrats in das Beschichtungssystem über eine Einschleuskammer;
b) Transportieren des Substrats in eine erste Transferkammer;
c) Transportieren des Substrats in entweder eine erste oder eine zweite Prozesskammer zur Bearbeitung des Substrats mittels eines ersten Prozesses;
d) Transportieren des Substrats in eine zweite Transferkammer; und
e) Transportieren des Substrats in entweder eine dritte oder eine vierte Prozesskammer zur Bearbeitung des Substrats mittels eines zweiten Prozesses.

12. Verfahren nach Anspruch 11,
**dadurch gekennzeichnet, dass**
das Verfahren weiter die folgenden Schritte umfasst:
f) Transportieren des Substrats von der dritten Prozesskammer oder der vierten Prozesskammer in die zweite Transferkammer; und
g) Transportieren des Substrats in die erste Prozesskammer oder die zweite Prozesskammer zur Bearbeitung des Substrats mittels eines dritten Prozesses.

13. Verfahren nach Anspruch 11 oder 12,
**dadurch gekennzeichnet, dass**
der Schritt g) das Transportieren des Substrats in dieselbe Prozesskammer wie im Schritt c) zur Bearbeitung des Substrats mittels eines dritten Prozesses umfasst.

14. Verfahren nach Anspruch 11, 12 oder 13,
**dadurch gekennzeichnet, dass**
das Verfahren weiter die Schritte h) Transportieren des Substrats in die erste Transferkammer; und i) Transportieren des Substrats in eine Ausschleuskammer umfasst.

15. Verfahren nach einem der Ansprüche 11 bis 14,
**dadurch gekennzeichnet, dass**
das Verfahren zur Herstellung eines TFT-Dünnfilmtransistors vorgesehen ist.

## Revendications

1. Système de revêtement (1) pour traiter un substrat, comprenant :
un agencement de chambres comprenant une première chambre de traitement (5) et une seconde chambre de traitement (9) ;
ladite première chambre de traitement (8) étant agencée sur une voie d'avancement (F) d'une partie en ligne dudit système de revêtement (1) et ladite seconde chambre de traitement (9) étant agencée sur une voie de retour (R) d'une partie en ligne dudit système de revêtement (1) ;
**caractérisé en ce que** :
ladite première chambre de traitement (8) et ladite seconde chambre de traitement (9) sont tous deux agencées entre une première chambre de transfert (5) et une seconde chambre de transfert (10) configurées pour transférer un substrat de la voie d'avancement (F) de la première partie en ligne vers la voie de retour (R) de la seconde partie en ligne et vice versa.

2. Système de revêtement (1) selon la revendication 1,
**caractérisé en ce que** :
ledit agencement de chambres comprend une station de verrouillage-déverrouillage (2) pour verrouiller un substrat dans le système de revêtement (1) et/ou pour déverrouiller un substrat par rapport au système de revêtement (1), respectivement ;
la première chambre de traitement (8) et la seconde chambre de traitement (9) étant agencées en ligne avec la station de verrouillage-déverrouillage (2), la première chambre de transfert (5), et la seconde chambre de transfert (10).

3. Système de revêtement (1) selon la revendication 1 ou 2, **caractérisé en ce que** ladite première chambre de traitement (8) et ladite seconde chambre de traitement (9) comprennent des outils de revêtement servant à déposer une couche sur un substrat au moyen d'un premier traitement de revêtement.

4. Système de revêtement (1) selon l'une quelconque des revendications précédentes, **caractérisé en ce que** ledit agencement de chambres comprend au moins une troisième chambre de traitement (13) pour traiter un substrat, dans lequel ladite troisième chambre de traitement (13) est couplée à ladite seconde chambre de transfert (10).

5. Système de revêtement (1) selon l'une quelconque des revendications précédentes, **caractérisé en ce que** ledit agencement de chambres comprend une quatrième chambre de traitement (14) agencée parallèlement à la troisième chambre de traitement (13) couplée à ladite seconde chambre de transfert (10).

6. Système de revêtement (1) selon l'une quelconque des revendications précédentes, **caractérisé en ce que** ladite troisième chambre de traitement (13) et ladite quatrième chambre de traitement (14) comprennent des outils de revêtement permettant de déposer une couche sur un substrat à l'aide d'un second traitement de revêtement.

7. Système de revêtement (1) selon l'une quelconque des revendications précédentes, **caractérisé en ce que** ladite station de verrouillage-déverrouillage (2) comprend une chambre de verrouillage (3) et une chambre de déverrouillage (4).

8. Système de revêtement (1) selon l'une quelconque des revendications précédentes, **caractérisé en ce que** ladite première chambre de transfert (5) est reliée à ladite première chambre de traitement (3) et à ladite seconde chambre de traitement (4), ladite première chambre de traitement (3) et ladite seconde chambre de traitement (4) étant reliées à ladite seconde chambre de transfert (10), et ladite troisième chambre de traitement (13) et ladite quatrième chambre de traitement (14) étant reliées à ladite seconde chambre de transfert (10).

9. Système de revêtement (1) selon l'une quelconque des revendications précédentes, **caractérisé en ce que** ladite première chambre de transfert (5) comprend un premier module pivotant (6) doté d'au moins un support de couche (7a, 7b) servant à supporter un substrat.

10. Système de revêtement (1) selon l'une quelconque des revendications précédentes, **caractérisé en ce que** ladite seconde chambre de transfert (10) comprend un second module pivotant (11) doté d'au moins un support de couche (12a, 12b) servant à supporter un substrat.

11. Procédé de revêtement d'un substrat dans un système de revêtement selon l'une quelconque des revendications précédentes, comprenant les étapes consistant à :
a) verrouiller un substrat dans ledit système de revêtement via une chambre de verrouillage ;
b) transporter ledit substrat dans une première chambre de transfert ;
c) transporter ledit substrat soit dans un première soit dans une seconde chambre de traitement en vue de traiter ledit substrat à l'aide d'un premier traitement ;
d) transporter ledit substrat dans une seconde chambre de transfert ; et
e) transporter ledit substrat soit dans une troisième soit dans une quatrième chambre de traitement en vue de traiter ledit substrat à l'aide d'un second traitement.

12. Procédé selon la revendication 11, **caractérisé en ce que** le procédé comprend en outre les étapes suivantes :
f) transporter ledit substrat de ladite troisième chambre de traitement ou de ladite quatrième chambre de traitement dans ladite seconde chambre de transfert ; et
g) transporter ledit substrat dans ladite première chambre de traitement ou ladite seconde chambre de traitement pour traiter ledit substrat à l'aide du même traitement.

13. Procédé selon la revendication 11 ou 12, **caractérisé en ce que** l'étape g) comprend le transport dudit substrat dans la même chambre de traitement qu'à l'étape c) pour traiter ledit substrat à l'aide d'un troisième traitement.

14. Procédé selon la revendication 11, 12, ou 13, **caractérisé en ce que** le procédé comprend les étapes supplémentaires consistant à h) transporter ledit substrat dans ladite première chambre de transfert ; et i) transporter ledit substrat dans une chambre de déverrouillage.

15. Procédé selon l'une quelconque des revendications 11 à 14, **caractérisé en ce que** ledit procédé est conçu pour produire un transistor en couches minces de type TFT.
